# EUROPEAN PATENT APPLICATION

(11) **EP 4 447 224 A1**
(43) Date of publication of application: **16.10.2024**
(21) Application number: 23167315.3
(22) Date of filing: 11.04.2023
(51) Int. Cl.: H01Q 1/22, H01Q 1/52, H01Q 9/04, H01Q 21/06

(54) **ANTENNA PACKAGE**

(71) Applicant: NXP B.V., 5656 AG Eindhoven (NL)
(72) Inventor: Acar, Mustafa, 5656AG Eindhoven (NL); Gong, Zhiwei, 5656AG Eindhoven (NL); Wenzel, Robert Joseph, 5656AG Eindhoven (NL); Zhou, Tingdong, 5656AG Eindhoven (NL)
(74) Representative: Miles, John Richard

(57) **Abstract**

An antenna package and method of manufacturing an antenna package is disclosed. The antenna package includes a first substrate and second substrate in a stacked arrangement. A first plurality of patch antennas and a plurality of decoupling capacitors is arranged on a first major surface of the first substrate. One or more decoupling capacitor of the plurality of decoupling capacitors is located between adjacent patch antennas of the first plurality of patch antennas. The second substrate includes a second plurality of patch antennas. One or more decoupling capacitors of the plurality of decoupling capacitors includes a first terminal configured to be in contact with the first substrate and a second terminal configured to be in contact with the first substrate and the second substrate.

## Description

### FIELD

This disclosure relates to an antenna package and a corresponding method.

### BACKGROUND

RF integrated circuit packages may include an array of patch antennas. The patch antennas may be constructed as a package-on-package (POP) in which one substrate typically a multi-layer printed circuit board may have a feed patch antenna patterned on one of other surfaces layer and a second substrate may have the parasitic patch antenna patterned on one of the surfaces of the second substrate. A gap between the first and second substrate partially determines the resonance properties of the resulting antenna. Such RF integrated circuit packages may implement modules for Wireless LAN (WLAN), 5G or 6G communication applications. Supply decoupling capacitors are typically required in such applications but increasing RF frequencies may place a constraint on the acceptable RF component sizes.

### SUMMARY

Aspects of the disclosure are defined in the accompanying claims. In a first aspect, there is defined an antenna package comprising a stacked arrangement of : a first substrate ; a first plurality of patch antennas arranged on a first major surface of the first substrate; a plurality of decoupling capacitors arranged on the first major surface, wherein at least one decoupling capacitor of the plurality of decoupling capacitors is located between adjacent patch antennas of the first plurality of patch antennas; and a second substrate comprising a second plurality of patch antennas ; wherein the at least one decoupling capacitor of the plurality of decoupling capacitors comprises a first terminal configured only to be in contact with the first substrate and a second terminal configured to be in contact with the first substrate and the second substrate.

In some embodiments, the second terminal of the at least one decoupling capacitor comprises a metal region extending from a first surface of the capacitor in contact with the first substrate to a second surface of the capacitor in contact with the second substrate.

In some embodiments, the metal region of the second terminal extends across two sidewalls and the second surface of the at least one decoupling capacitor.

In some embodiments, the first terminal of the at least one capacitor is configured to be coupled to a first reference voltage and the second terminal of the at least one capacitor is configured to be coupled to a second reference voltage. In some embodiments, the metal region of the second terminal extends across four sidewalls and the second surface of the at least one decoupling capacitor,

In some embodiments, the first terminal of the at least one capacitor is configured to be coupled to a first reference voltage and the second terminal of the at least one capacitor is configured to be coupled to a second reference voltage.

In some embodiments, first reference voltage is a supply voltage and the second reference voltage is a ground.

In some embodiments, the plurality of decoupling capacitors are configured to form a ground wall between adjacent patch antennas.

In some embodiments, the separation between the first substrate and the second substrate is defined by the height of the at least one decoupling capacitor.

In some embodiments, the plurality of decoupling capacitors are arranged around the perimeter of each patch antenna.

In some embodiments, each patch antenna of the first plurality of patch antennas and the second plurality of patch antennas is a square or a circular shape.

In some embodiments, each patch antenna of the first plurality of patch antennas is arranged below a corresponding patch antenna of the second plurality of patch antennas.

Embodiments of the antenna package may be included in an antenna package-on-package, an RF integrated circuit and/or other integrated circuit packages.

In a second aspect there is defined a method of manufacturing an antenna, the method comprising: providing a first substrate ;providing a first plurality of patch antennas arranged on a first major surface of the first substrate; providing a plurality of decoupling capacitors arranged on the first major surface, wherein at least one decoupling capacitor of the plurality of decoupling capacitors is located between adjacent patch antennas of the first plurality of patch antennas; providing a plurality of solder balls on the first major surface of the first substrate; providing a stacked arrangement of the first substrate and a second substrate, the second substrate comprising a second plurality of patch antennas arranged on a first major surface of the second substrate, and a second major surface opposite the first major surface; applying a reflow process such that a first terminal of the at least one decoupling capacitor is configured to only be in contact with the first major surface of the first substrate and a second terminal of the at least one decoupling capacitor is configured to be in contact with the first major surface of the first substrate and the second major surface of the second substrate.

In some embodiments, the method further comprising compressing the first substrate and the second substrate during the reflow process.

In some embodiments, the separation between the first substrate and the second substrate is defined by the height of the at least one decoupling capacitor.

In some embodiments, the plurality of decoupling capacitors are arranged around the perimeter of each patch antenna.

In some embodiments, wherein each patch antenna of the first plurality of patch antennas and the second plurality of patch antennas is a square or a circle..

In some embodiments, each patch antenna of the first plurality of patch antennas is arranged below a corresponding patch antenna of the second plurality of patch antennas.

In some embodiments, the plurality of decoupling capacitors are configured to form a ground wall between adjacent patch antennas.

In a third aspect, there is provided an antenna package comprising a stacked arrangement of : a first substrate; a first plurality of patch antennas arranged on a first major surface of the first substrate; a plurality of decoupling capacitors arranged on the first major surface between adjacent patch antennas of the first plurality of patch antennas; and a second substrate comprising a second plurality of patch antennas; wherein at least one decoupling capacitor of the plurality of decoupling capacitors comprises a first terminal configured to be in contact with the first substrate and a second terminal configured to be in contact with the first substrate and the second substrate; wherein the second terminal of the at least one decoupling capacitor comprises a metal region extending from a top surface of the capacitor in contact with the first substrate to a bottom surface of the capacitor in contact with the second substrate; wherein the metal region of the second terminal extends across at least two sidewalls and the top surface of the at least one decoupling capacitor.

### BRIEF DESCRIPTION OF THE DRAWINGS

In the figures and description like reference numerals refer to like features. Embodiments are now described in detail, by way of example only, illustrated by the accompanying drawings in which:
Figure 1A shows a plan view of an antenna package.
Figure 1B shows a cross-section view of the antenna package of figure 1A.
Figure 1C show a plan view of a further detail of the antenna package of figure 1A.
Figure 1D show a cross-section of a further detail of the antenna package of figure 1A.
Figure 2A shows a plan view of an antenna package according to an embodiment.
Figure 2B shows a cross-section view of the antenna package of figure 2A.
Figure 2C show a plan view of a further detail of the antenna package of figure 2A.
Figure 2D show a cross-section of a further detail of the antenna package of figure 2A.
Figure 3A shows a cross section of the antenna package of figure 2A before reflow.
Figure 3B shows a cross section of the antenna package of figure 2A after reflow.
Figures 4A and Figure 4B show alternative configurations of shielded capacitors for an antenna package of one or more embodiments.
Figure 5A shows a plan view of an antenna package according to an embodiment
Figure 5B shows a first cross-section view of the antenna package of figure 5A.
Figure 5C shows a second cross-section view of the antenna package of figure 5A.
Figure 6 illustrates a method of manufacturing the antenna package according to an embodiment.

### DETAILED DESCRIPTION OF EMBODIMENTS

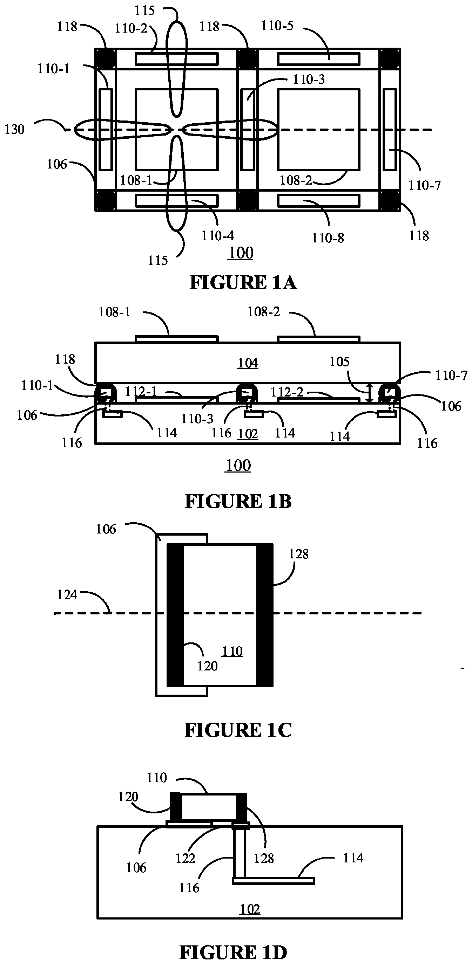

Figures 1A-1D show various aspects of an antenna package 100. Referring to figures 1A and 1B, figure 1A shows a plan view of the antenna package 100 and figure 1B shows a cross-section view of the antenna package 100 drawn along cross-section line 130 shown in figure 1A. Patch antennas 112-1, 112-2 are formed on a top surface ( first major surface) of a first substrate 102, and corresponding patch antennas 108-1, 108-2 are formed on a top surface of a second substrate 104, which as illustrated is above the first substrate 102. Consequently the second substrate 104 may be considered to be stacked on the first substrate 102 in a package-on-package (POP) arrangement. Pairs of patch antennas 108-1, 112-1 and 108-2, 112-2 form one antenna element of an array. A signal may be provided to the patch antennas 112-1, 112-2 which may be referred to as feed antennas via feed lines (not shown). The corresponding patch antennas 108-1, 108-2 which may be referred to as parasitic antennas are capacitively coupled to the respective antenna elements 112-1, 112-2. Decoupling capacitors 110-1, 110-2, 110-3, 110-4 are arranged around the perimeter of the patch antenna 112-1 and corresponding patch antenna 108-1. Similarly, decoupling capacitors 110-3, 110-5, 110-7, 110-8 are arranged around the perimeter of the patch antenna 112-2 and corresponding patch antenna 108-2. A metal ground region 106 formed on the first substrate 102 may surround the patch antennas 108. Solder balls 118 attach the first substrate 102 and second substrate 104 with the height of the solder balls determining the gap 105 between the first and second substrates 102, 104.

Each of the decoupling capacitors 110 has four side-walls, a top surface, and a bottom surface and may have a first terminal connected to a voltage supply rail 114 by via 116 and a second terminal connected to ground 106. Referring to figures 1C and 1D, figure 1C shows a plan view of a further detail of the connections of a decoupling capacitor 110, figure 1D shows a cross section along dashed line 124 of figure 1C. A first terminal 128 is connected by metal contact 122 and via 116 to the supply rail 114. A second terminal 120 is connected to the metal ground region 106.

The gap 105 between the top of the first substrate and bottom of the second substrates in antenna package 100 may be determined by solder balls 118 after reflow. This height may vary due to variations in the manufacturing process such as substrate warpage during reflow, solder pad / solder mask opening variations and solder ball size variations resulting in a variation in height which may be +/- 15%. Consequently this will result in RF performance variation. Furthermore since the antenna radiation 115 may interfere with radiation from adjacent antennas, this may further affect the RF performance.

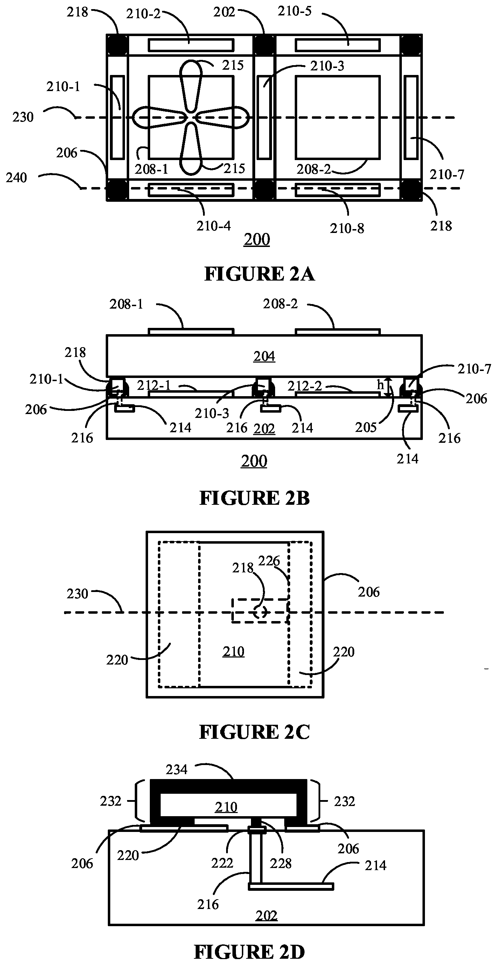

Figures 2A, 2B, 2C, and 2D show various aspects of an antenna package 200 according to an embodiment. The features of first and second substrates 202, 204, patch antennas 208 (208-1, 208-2), 212 (212-1, 212-2), and solder balls 218 correspond to the equivalent features (102,104,108,112,118) of antenna package 100. The decoupling capacitors 210 (210-1, 210-2, 210-3, 210-4, 210-5, 210-6, 210-7, 210-8) may be implemented as a shielded capacitor with a first terminal 228 located on the underside of the decoupling capacitor as illustrated to contact a first reference voltage node 214 which may provide a supply voltage via contact 222 and via 216. A second terminal 220 extends from the underside of the capacitor around the sidewalls 232 and the top 234 of the capacitor 210 and is connected to metal region 206 which may provide a second reference voltage which may be a ground. The second terminal 220 may form a ground shield or ground wall. Decoupling capacitors 210 may be made for example using methods disclosed in European patent application EP23164715.7 and corresponding US patent application US18/067649 . The decoupling capacitors 210 of the antenna package 200 may be arranged to form a ground wall which may enable a ground continuity between the antenna patches. The ground wall formed by decoupling capacitors 210 around each antenna 208, 212 may also improve the isolation of antenna radiation 215 between antennas, for example between antennas 208-1, 208-2 and between 212-1, 212-2 which may reduce crosstalk. Moreover, the decoupling capacitors 210 may act as a height setter between the top patches 208 and bottom patches 212 which may affect the performance of the antennas. Referring to figures 2C and 2D, figure 2C shows a plan view of a further detail of the connections of a decoupling capacitor 210, figure 2D shows a cross section along dashed line 230 of figure 2C. The first terminal 228 is connected by metal contact 222 located in a gap 226 in the metal ground region 206 by via 216 to the first reference voltage node 214. The second terminal 220 is connected to the metal ground region 206. In other examples the first voltage may be a ground and the second reference voltage may be a supply voltage. Connecting the decoupling capacitors 210 in this way may also provide shielding and improve the isolation of antenna radiation 215 between antennas.

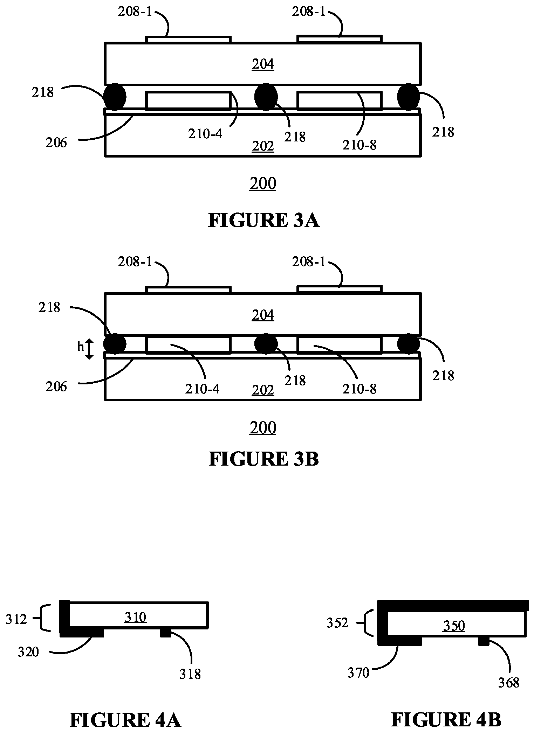

Figures 3A and 3B show various aspects of the antenna package 200 during manufacture before and after reflow. Figure 3A shows the status of the package before reflow along cross section 240 of figure 2A. Figure 3B shows the antenna package 200 after reflow. The inter region spacing 205 between the first substrate 202 and the second substrate 204 is determined by the height of the decoupling capacitor 210 rather than then height of the solder ball. In some examples, additional force may be applied to the second substrate 204 so that inter region gap 205 is the same as the height of the capacitor 210.

Figure 4A shows an alternative example of a shielded capacitor 310 having a first terminal 318 and second terminal 320 which may be used to implement decoupling capacitor 210. In this example, the shielding provided by the second terminal 320 extends partially along the underside and a sidewall 312 of the capacitor 310. Figure 4B shows an alternative example of a shielded capacitor 350 having a first terminal 368 and second terminal 370 which may be used to implement decoupling capacitor 210. In this example, the shielding provided by the second terminal 370 extends along the underside, one sidewall 352 and across the top surface of the capacitor 350 as illustrated. In other examples, other shielded capacitors may be provided having the ground or shield terminal extending partially or completely around one or more sidewalls and the top surfaces of the capacitor.

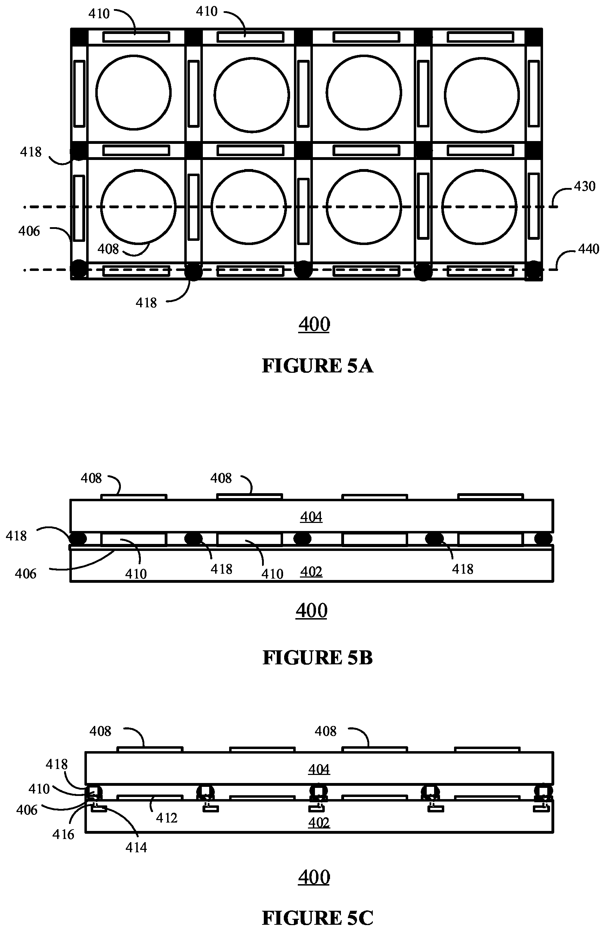

Figure 5A illustrates a plan view of an antenna package 400 including an array of 8 antennas according to an embodiment. The patch antennas 408, 412 are circular, in other respects, the first and second substrates 402, 404, metal ground region 406, decoupling capacitors 410, supply rails 414 vias 416, and solder balls 418 correspond to the equivalent features in antenna packages 100, 200. Figure 5B shows a cross section of the antenna package 400 taken across dashed line 440. Figure 5C shows a cross section of the antenna package 400 taken across dashed line 430. The decoupling capacitors 410 may be shielded capacitors for example shielded capacitors 210, 310, 350 providing improved isolation between adjacent antenna patches. The ground wall formed by decoupling capacitors 410 around each antenna 408, 412 may also improve the isolation between antennas 408, 412, which may reduce crosstalk similarly to antenna package 200. Moreover, the decoupling capacitors 410 act as a height setter between the top patch 408 and bottom patch 412 which determines the performance of the antennas 408, 412.

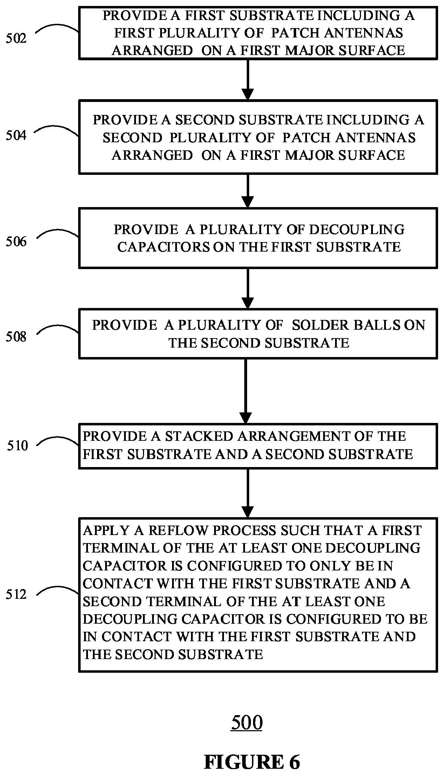

Figure 6 shows a method of manufacturing an antenna package 500. In step 502 a first substrate is provided, including a first plurality of metal patch antennas is provided on a first major surface of the first substrate, for example metal patch antennas 112, 212, 412. In step 504 a second substrate is provided, including a first plurality of metal patch antennas is provided on a first major surface of the second substrate, for example metal patch antennas 108, 208, 408. In step 506 a plurality of decoupling capacitors, for example 310, 350 are provided on the first substrate. The decoupling capacitors are arranged around the perimeter of each patch antenna. In step 508 a plurality of solder balls, for example solder balls 118, 218 may be provided on the second substrate. In step 510, the second substrate is placed on the first substrate. A second major surface of the second substrate is in contact with the solder balls resulting in a package-on-package or stacked arrangement of first and second substrates. In step 512 a reflow process may be applied such that a first terminal of the at least one decoupling capacitor is configured to be in contact with the first substrate and a second terminal of the at least one decoupling capacitor is configured to be in contact with the first substrate and the second substrate.

Supply de-coupling capacitors are widely used in many applications ranging from WLAN to 6G modules. Increasing RF frequencies place a constraint on the acceptable RF component sizes. Embodiments of the antenna package and method described herein with the disclosed arrangement of supply de-coupling capacitors may form ground walls as part of the patch antenna array. The shielding of the de-coupling capacitors may enable a ground continuity between the RF patches and may also serve as isolation between antennas to reduce crosstalk. Moreover, the de-coupling capacitors may act as a height setter between the top patch and bottom patch to reduce manufacturing variation of the height which may improve performance of the antenna. In wireless applications with increasing frequencies, the utilization of discrete components such as supply decoupling capacitors becomes more and more challenging due to space constraints. Embodiments of the antenna package and method described herein with the disclosed arrangement of supply de-coupling capacitors may decrease the real estate of such RF components.

An antenna package and method of manufacturing an antenna package is disclosed. The antenna package includes a first substrate and second substrate in a stacked arrangement. A first plurality of patch antennas and a plurality of decoupling capacitors is arranged on a first major surface of the first substrate. One or more decoupling capacitor of the plurality of decoupling capacitors is located between adjacent patch antennas of the first plurality of patch antennas. The second substrate includes a second plurality of patch antennas. One or more decoupling capacitors of the plurality of decoupling capacitors includes a first terminal configured to be in contact with the first substrate and a second terminal configured to be in contact with the first substrate and the second substrate.

Because the apparatus implementing the present invention is, for the most part, composed of electronic components and circuits known to those skilled in the art, circuit details will not be explained in any greater extent than that considered necessary as illustrated above, for the understanding and appreciation of the underlying concepts of the present invention and in order not to obfuscate or distract from the teachings of the present invention.

Moreover, the terms "front," "back," "top," "bottom," "over," "under", "side" and the like in the description and in the claims, if any, are used for descriptive purposes and not necessarily for describing permanent relative positions. It is understood that the terms so used are interchangeable under appropriate circumstances such that the embodiments of the invention described herein are, for example, capable of operation in other orientations than those illustrated or otherwise described herein.

Although the appended claims are directed to particular combinations of features, it should be understood that the scope of the disclosure of the present invention also includes any novel feature or any novel combination of features disclosed herein either explicitly or implicitly or any generalisation thereof, whether or not it relates to the same invention as presently claimed in any claim and whether or not it mitigates any or all of the same technical problems as does the present invention.

Features which are described in the context of separate embodiments may also be provided in combination in a single embodiment. Conversely, various features which are, for brevity, described in the context of a single embodiment, may also be provided separately or in any suitable sub combination.

The applicant hereby gives notice that new claims may be formulated to such features and/or combinations of such features during the prosecution of the present application or of any further application derived therefrom.

For the sake of completeness it is also stated that the term "comprising" does not exclude other elements or steps, the term "a" or "an" does not exclude a plurality, a single processor or other unit may fulfil the functions of several means recited in the claims and reference signs in the claims shall not be construed as limiting the scope of the claims.

## Claims

1. An antenna package comprising a stacked arrangement of:
a first substrate ;
a first plurality of patch antennas arranged on a first major surface of the first substrate;
a plurality of decoupling capacitors arranged on the first major surface, wherein at least one decoupling capacitor of the plurality of decoupling capacitors is located between adjacent patch antennas of the first plurality of patch antennas; and
a second substrate comprising a second plurality of patch antennas ;
wherein the at least one decoupling capacitor of the plurality of decoupling capacitors comprises a first terminal configured only to be in contact with the first substrate and a second terminal configured to be in contact with the first substrate and the second substrate.

2. The antenna package of claim 1, wherein the second terminal of the at least one decoupling capacitor comprises a metal region extending from a first surface of the capacitor in contact with the first substrate to a second surface of the capacitor in contact with the second substrate.

3. The antenna package of claim 2, wherein the metal region of the second terminal extends across two sidewalls and the second surface of the at least one decoupling capacitor.

4. The antenna package of claim 3, wherein the metal region of the second terminal extends across four sidewalls and the second surface of the at least one decoupling capacitor.

5. The antenna package of any preceding claim, wherein the first terminal of the at least one decoupling capacitor is configured to be coupled to a first reference voltage and the second terminal of the at least one capacitor is configured to be coupled to a second reference voltage.

6. The antenna package of claim 5, wherein the first reference voltage is a supply voltage and the second reference voltage is a ground.

7. The antenna package of any preceding claim, wherein the plurality of decoupling capacitors are configured to form a ground wall between adjacent patch antennas.

8. The antenna package of any preceding claim, wherein a separation between the first substrate and the second substrate is defined by the height of the at least one decoupling capacitor.

9. The antenna package of any preceding claim, wherein the plurality of decoupling capacitors are arranged around the perimeter of each patch antenna.

10. The antenna package of any preceding claim, wherein each patch antenna of the first plurality of patch antennas and the second plurality of patch antennas is a square or a circular shape.

11. The antenna package of any preceding claim, wherein each patch antenna of the first plurality of patch antennas is arranged below a corresponding patch antenna of the second plurality of patch antennas.

12. An antenna package-on-package comprising the antenna package of any preceding claim.

13. An RF integrated circuit comprising the antenna package of any of claims 1 to 11.

14. A method of manufacturing an antenna, the method comprising:
providing a first substrate ;
providing a first plurality of patch antennas arranged on a first major surface of the first substrate;
providing a plurality of decoupling capacitors arranged on the first major surface, wherein at least one decoupling capacitor of the plurality of decoupling capacitors is located between adjacent patch antennas of the first plurality of patch antennas;
providing a plurality of solder balls on the first major surface of the first substrate;
providing a stacked arrangement of the first substrate and a second substrate, the second substrate comprising a second plurality of patch antennas arranged on a first major surface of the second substrate, and a second major surface opposite the first major surface; and
applying a reflow process such that a first terminal of the at least one decoupling capacitor is configured to only be in contact with the first major surface of the first substrate and a second terminal of the at least one decoupling capacitor is configured to be in contact with the first major surface of the first substrate and the second major surface of the second substrate.

15. The method of claim 14 further comprising: compressing the first substrate and the second substrate during the reflow process.

## Amended claims

### Amended claims in accordance with Rule 137(2) EPC.

1. An antenna package (200, 400) comprising a stacked arrangement of:
a first substrate (202, 402) ;
a first plurality of patch antennas (212, 412) arranged on a first major surface of the first substrate (202, 402) ;
a plurality of decoupling capacitors (210, 310, 350, 410) arranged on the first major surface, wherein at least one decoupling capacitor of the plurality of decoupling capacitors is located between adjacent patch antennas of the first plurality of patch antennas (212, 412); and
a second substrate (204, 404) comprising a second plurality of patch antennas (208, 408) ;
wherein the at least one decoupling capacitor (210, 310, 350, 410) of the plurality of decoupling capacitors comprises a first terminal (228, 428) configured only to be in contact with the first substrate (202, 402) and a second terminal (220, 320, 370) configured to be in contact with the first substrate (202, 402) and the second substrate (204, 404).

2. The antenna package (200, 400) of claim 1, wherein the second terminal (220, 320, 370) of the at least one decoupling capacitor (210, 310, 350, 410) comprises a metal region extending from a first surface of the capacitor in contact with the first substrate (202, 402) to a second surface of the capacitor in contact with the second substrate (204, 404).

3. The antenna package (200, 400) of claim 2, wherein the metal region of the second terminal (220, 370) extends across two sidewalls (232, 352) and the second surface of the at least one decoupling capacitor (210, 350).

4. The antenna package (200, 400) of claim 3, wherein the metal region of the second terminal (220, 370) extends across four sidewalls (232, 352) and the second surface of the at least one decoupling capacitor (210, 350).

5. The antenna package (200, 400) of any preceding claim, wherein the first terminal (228, 428) of the at least one decoupling capacitor (210, 310, 350, 410) is configured to be coupled to a first reference voltage and the second terminal (220, 420) of the at least one capacitor is configured to be coupled to a second reference voltage.

6. The antenna package (200, 400) of claim 5, wherein the first reference voltage is a supply voltage and the second reference voltage is a ground.

7. The antenna package (200, 400) of any preceding claim, wherein the plurality of decoupling capacitors are configured to form a ground wall between adjacent patch antennas.

8. The antenna package (200, 400) of any preceding claim, wherein a separation between the first substrate and the second substrate is defined by the height of the at least one decoupling capacitor.

9. The antenna package of any preceding claim, wherein the plurality of decoupling capacitors (200, 400) are arranged around the perimeter of each patch antenna (212, 412, 208, 408).

10. The antenna package of any preceding claim, wherein each patch antenna of the first plurality of patch antennas (212, 412) and the second plurality of patch antennas (208, 408) is a square or a circular shape.

11. The antenna package of any preceding claim, wherein each patch antenna of the first plurality of patch antennas (212, 412) is arranged below a corresponding patch antenna of the second plurality of patch antennas (208, 408) .

12. An antenna package-on-package comprising the antenna package of any preceding claim.

13. An RF integrated circuit comprising the antenna package of any of claims 1 to 11.

14. A method (500) of manufacturing an antenna, the method comprising:
providing a first substrate (202, 402);
providing (502) a first plurality of patch antennas (212, 412) arranged on a first major surface of the first substrate (202, 402);
providing (506) a plurality of decoupling capacitors (210, 310, 350, 410) arranged on the first major surface, wherein at least one decoupling capacitor of the plurality of decoupling capacitors is located between adjacent patch antennas of the first plurality of patch antennas (212, 412);
providing (508) a plurality of solder balls on the first major surface of the first substrate (202, 402);
providing (510) a stacked arrangement of the first substrate (202, 402) and a second substrate (204, 404), the second substrate comprising a second plurality of patch antennas (208, 408) arranged on a first major surface of the second substrate (204, 404), and a second major surface opposite the first major surface; and
applying a reflow process (512) such that a first terminal (228, 318, 368) of the at least one decoupling capacitor (210, 310, 350, 410) is configured to only be in contact with the first major surface of the first substrate (202, 402) and a second terminal (220, 320, 370) of the at least one decoupling capacitor is configured to be in contact with the first major surface of the first substrate (202, 402) and the second major surface of the second substrate (204, 404).

15. The method of claim 14 further comprising: compressing the first substrate (202, 402) and the second substrate during the reflow process (204, 404).
